# EUROPÄISCHE PATENTSCHRIFT

(11) **EP 3 621 160 B1**
(45) Veröffentlichungstag und Bekanntmachung des Hinweises auf die Patenterteilung: **10.04.2024**
(21) Anmeldenummer: 19181756.8
(22) Anmeldetag: 21.06.2019
(51) Int. Cl.: H01R 12/57, H01R 13/24, H05K 3/32, H05K 3/28, H05K 3/34, H01R 12/71, H01R 12/70

(54) **ELEKTRONISCHES STEUERMODUL UND VERFAHREN ZUM HERSTELLEN EINES ELEKTRONISCHEN STEUERMODULS**
ELECTRONIC CONTROL MODULE AND METHOD FOR PRODUCING SAME
MODULE DE COMMANDE ÉLECTRONIQUE ET PROCÉDÉ DE FABRICATION D'UN MODULE DE COMMANDE ÉLECTRONIQUE

(30) Priorität: 06.09.2018 DE 102018215149
(43) Veröffentlichungstag der Anmeldung: 11.03.2020
(73) Patentinhaber: Robert Bosch GmbH, 70442 Stuttgart (DE)
(72) Erfinder: Sippel, Bernd-Guenter, 71701 Schwieberdingen (DE); Zweigle, Peter, 71254 Ditzingen (DE); Deringer, Helmut, 74391 Erligheim (DE); Zeleny, Franco, 74354 Besigheim (DE); Welter, Aline, 99817 Eisenach (DE); Wolfangel, Nadja, 71686 Remseck (DE); Lenz, Michael, 70825 Korntal-Muenchingen (DE); Hajdu, Peter, 1118 Budapest (HU); Katzenwadel, Uwe, 71739 Oberriexingen (DE); Bueyuekgoez, Harun, 72793 Pfullingen (DE); Leschik, Mario, 72770 Reutlingen (DE)

(56) Entgegenhaltungen:
- EP-A1- 3 291 654
- CN-A- 108 321 572
- DE-A1-102005 036 563
- DE-A1-102016 224 666
- DE-A1-102017 202 962
- US-B2- 8 203 845

## Beschreibung

### Gebiet der Erfindung

Die Erfindung betrifft ein elektronisches Steuermodul und ein Verfahren zum Herstellen eines elektronischen Steuermoduls.

### Stand der Technik

Im KFZ-Automatikgetriebe werden zur Steuerung der Kupplungs- und Schaltvorgänge elektronische Steuermodule eingesetzt, die im ölgefüllten Getriebeinnenraum eingebaut sind. Zur Erfassung von Drehzahlen und/oder Position von Zahnrändern und/oder Schaltelementen in Getrieben werden unterschiedliche Sensoren und/oder elektrische Bauelemente benötigt, welche elektrisch und mechanisch mit einer Leiterplatte des elektronischen Steuermoduls verbunden sind.

Nachteilig an bisher bekannten elektronischen Steuermodulen ist, dass die elektrische Verbindung zwischen der Leiterplatte und dem elektronischen Bauelement technisch aufwändig ist, insbesondere da elektronische Bauelemente unterschiedliche Höhen aufweisen können.

Aus der DE 10 2005 036 563 A1 ist ein elektronisches Steuergerät bekannt, das eine Leiterplatte und mindestens ein elektronisches Bauelement aufweist, wobei auf der Leiterplatte mindestens ein in einer Richtung, die senkrecht zu einer Oberfläche der Leiterplatte verläuft, federnd ausgebildetes Verbindungselement zum elektrischen Verbinden des elektronischen Bauelements mit der Leiterplatte angeordnet ist, wobei das Verbindungselement mit der Leiterplatte elektrisch und mechanisch verbunden ist.

Aus der CN 108 321 572 A ist eine CPU bekannt, die federnd ausgebildete Verbindungselemente zur Kontaktierung mit einer Leiterplatte verwendet.

WO2018153595 A1 offenbart in Abbildung 1 ein Kontaktelement auf einem Sockel welcher auf einer Leiterplatte angeordnet ist. Das Kontaktelement ist parallel zur Oberfläche der Leiterplatte federnd ausgeführt.Die Leiterplatte und Teile des Bauelements und des Kontaktelements sind von einer Vergussmasse bedeckt.

### Offenbarung der Erfindung

Vor diesem Hintergrund werden mit dem hier vorgestellten Ansatz ein elektronisches Steuermodul bzw. ein Verfahren zum Herstellen eines elektronischen Steuermoduls gemäß den unabhängigen Ansprüchen vorgestellt. Vorteilhafte Weiterbildungen und Verbesserungen des hier vorgestellten Ansatzes ergeben sich aus der Beschreibung und sind in den abhängigen Ansprüchen beschrieben.

### Vorteile der Erfindung

Ausführungsformen der vorliegenden Erfindung können in vorteilhafter Weise ermöglichen, technisch einfach eine sichere elektrische Verbindung zwischen einem elektronischen Bauelement, z.B. einem Sensor, und einer Leiterplatte eines elektronischen Steuermoduls auch bei unterschiedlichen Bauhöhen des elektronischen Bauelements herzustellen.

Gemäß einem ersten Aspekt der Erfindung wird ein elektronisches Steuermodul, insbesondere für eine Getriebesteuerung, vorgeschlagen, umfassend eine Leiterplatte, und mindestens ein elektronisches Bauelement, insbesondere ein Sensorelement, dadurch gekennzeichnet, dass auf der Leiterplatte mindestens ein in einer Richtung, die senkrecht zu einer Oberfläche der Leiterplatte verläuft, federnd ausgebildetes Verbindungselement zum elektrischen Verbinden des elektronischen Bauelements mit der Leiterplatte angeordnet ist, wobei das Verbindungselement mit der Leiterplatte, insbesondere mittels einer Lötverbindung, vorzugsweise einer Reflow-Lötverbindung, elektrisch und mechanisch verbunden ist, wobei das elektronische Bauelement über jeweils eine Kontaktfläche mit dem Verbindungselement elektrisch verbunden ist, wobei zumindest ein Teil der Oberfläche der Leiterplatte, ein Teil des elektronischen Bauelements und ein Teil des Verbindungselements oder der Verbindungselemente flüssigkeitsdicht mit einem Vergussmaterial vergossen sind und wobei das elektronische Bauelement eine Trennwand zwischen zwei Kontaktflächen aufweist, wobei das Vergussmaterial derart zwischen der Trennwand und der Oberfläche der Leiterplatte angeordnet ist, dass zwei Verbindungselemente in zwei voneinander durch die Trennwand abgetrennten Kammern angeordnet sind.

Vorteilhaft hieran ist, dass durch die federnde Ausbildung des Verbindungselements typischerweise technisch einfach eine sichere elektrische Verbindung zwischen dem elektronischen Bauelement und der Leiterplatte vorhanden ist, auch wenn die elektronischen Bauelemente jeweils unterschiedliche Bauhöhen aufweisen. Die Verbindung zwischen dem Verbindungselement und dem elektronischen Bauelement weist hierdurch üblicherweise eine Berührung mit definierter Kontaktkraft auf. Das federnd ausgebildete Verbindungselement kann im Allgemeinen Toleranzen bzw. Bautoleranzen ausgleichen. Zudem können bei einer Befestigung des elektronischen Bauelements an der Leiterplatte mittels einer Lötverbindung bzw. einer Reflow-Lötverbindung in der Regel unterschiedliche Temperaturausdehnungskoeffizienten der verschiedenen Elemente ausgeglichen werden, da die Verbindung zwischen dem elektronischen Bauelement und dem Verbindungselement sich grundsätzlich von der Verbindung zwischen dem Verbindungselement und der Leiterplatte unterscheidet.

Gemäß einem zweiten Aspekt der Erfindung wird ein Verfahren zum Herstellen eines elektronischen Steuermoduls, insbesondere eines elektronischen Steuermoduls nach einem der vorhergehenden Ansprüche, vorgeschlagen, wobei das Verfahren folgende Schritte umfasst: Bereitstellen einer Leiterplatte mit mindestens einem mit der Leiterplatte elektrisch und mechanisch, insbesondere mittels einer Lötverbindung, vorzugsweise einer Reflow-Lötverbindung, verbundenen Verbindungselement, wobei das Verbindungselement in einer Richtung, die senkrecht zu einer Oberfläche der Leiterplatte ausgebildet ist, federnd ausgebildet ist; Bereitstellen eines elektronischen Bauelements mit mindestens einer Kontaktfläche zum elektrischen Verbinden des elektronischen Bauelements; und Anordnen des elektronischen Bauelements auf der Oberfläche der Leiterplatte derart, dass die Kontaktfläche des elektronischen Bauelements das Verbindungselement zum Herstellen einer elektrischen Verbindung zwischen dem elektronischen Bauelement und der Leiterplatte kontaktiert, wobei das Verfahren ferner folgende Schritte nach dem Anordnen des elektronischen Bauelements auf der Oberfläche der Leiterplatte aufweist:
Aufbringen eines flüssigen Vergussmaterials auf die Oberfläche der Leiterplatte derart, dass das Vergussmaterial zumindest einen Teil der Oberfläche der Leiterplatte, einen Teil des elektronischen Bauelements und einen Teil des Verbindungselements flüssigkeitsdicht mit einer Vergussmasse bedeckt; und Aushärten des Vergussmaterials.

Ein Vorteil hiervon ist, dass durch die federnde Ausbildung des Verbindungselements in der Regel technisch einfach eine sichere elektrische Verbindung zwischen dem elektronischen Bauelement und der Leiterplatte hergestellt wird, auch wenn die elektronischen Bauelemente jeweils unterschiedliche Bauhöhen aufweisen. Hierdurch kann die Verbindung zwischen dem Verbindungselement und dem elektronischen Bauelement im Allgemeinen eine Berührung mit definierter Kontaktkraft aufweisen. Durch das federnd ausgebildete Verbindungselement können typischerweise Toleranzen bzw. Bautoleranzen ausglichen werden. Zudem können bei einer Befestigung des elektronischen Bauelements an der Leiterplatte mittels einer Lötverbindung bzw. einer Reflow-Lötverbindung in der Regel unterschiedliche Temperaturausdehnungskoeffizienten der verschiedenen Elemente ausgeglichen werden, da die Verbindung zwischen dem elektronischen Bauelement und dem Verbindungselement sich grundsätzlich von der Verbindung zwischen dem Verbindungselement und der Leiterplatte unterscheidet.

Ideen zu Ausführungsformen der vorliegenden Erfindung können unter anderem als auf den nachfolgend beschriebenen Gedanken und Erkenntnissen beruhend angesehen werden.

Die Erfindung basiert somit insbesondere auf der Idee, dass eine federnd ausgebildete elektrische Verbindung zwischen einem Verbindungselement, das auf einer Leiterplatte angeordnet ist und elektrisch mit der Leiterplatte verbunden ist, und einem elektronischen Bauelement hergestellt wird bzw. werden kann, wodurch Toleranzen ausgeglichen werden können.

Gemäß einer Ausführungsform sind auf der Leiterplatte zwei Verbindungselemente zum elektrischen Verbinden des elektronischen Bauelements mit der Leiterplatte angeordnet, wobei jedes Verbindungselement mit der Leiterplatte, insbesondere mittels Löten, vorzugsweise mittels Reflow-Löten, elektrisch und mechanisch verbunden ist, und wobei das elektronische Bauelement jeweils über eine Kontaktfläche mit den Verbindungselementen elektrisch verbunden sind. Vorteilhaft hieran ist, dass das elektronische Bauelement typischerweise noch sicherer mit der Leiterplatte elektrisch verbunden ist. Insbesondere weisen somit beide Pole des elektronischen Bauelements eine elektrische Verbindung mit der Leiterplatte über federnd ausgebildete Verbindungselemente auf, so dass typischerweise Bauhöhenunterschiede und/oder Bautoleranzen und/oder unterschiedliche Wärmeausdehnungen besonders gut ausgeglichen werden können.

Gemäß einer Ausführungsform umfasst das elektronische Bauelement einen Positionierstift zum Ausrichten des elektronischen Bauelements relativ zu der Leiterplatte, und die Leiterplatte weist eine zu dem Positionierstift komplementäre Aussparung zum Aufnehmen des Positionierstifts auf, wobei der Positionierstift zumindest teilweise in der Aussparung angeordnet ist. Hierdurch wird typischerweise technisch einfach eine Ausrichtung des elektronischen Bauelements relativ zu der Leiterplatte erreicht. Zudem ist hierdurch im Allgemeinen ein Verrutschen des elektronischen Bauelements auf der Oberfläche der Leiterplatte oder parallel hierzu im Wesentlichen ausgeschlossen.

Gemäß einer Ausführungsform liegt ein flachgedrückter Teil des Positionierstifts zum Befestigen des elektronischen Bauelements an der Leiterplatte auf einer der Oberfläche der Leiterplatte gegenüberliegenden Rückseite der Leiterplatte auf. Vorteilhaft hieran ist, dass durch die Wärmeverstemmung des Positionierstifts das elektronische Bauelement typischerweise besonders sicher an der Leiterplatte befestigt ist. Insbesondere wird im Allgemeinen ein Bewegen des elektronischen Bauelements von der Oberfläche der Leiterplatte weg hierdurch sicher verhindert. Zudem wird im Allgemeinen ein Bewegen des elektronischen Bauelements relativ zu der Leiterplatte auch vor dem Aufbringen eines Vergussmaterials technisch einfach verhindert.

Erfindungsgemäß sind zumindest ein Teil der Oberfläche der Leiterplatte, ein Teil des elektronischen Bauelements und ein Teil des Verbindungselements oder der Verbindungselemente flüssigkeitsdicht mit einem Vergussmaterial vergossen. Hierdurch ist im Allgemeinen die elektrische Verbindung zwischen dem Verbindungselement bzw. den Verbindungselementen und der Leiterplatte technisch einfach vor Öl bzw. Getriebeöl geschützt. Zudem wird hierdurch typischerweise das elektronische Bauelement derart mit der Leiterplatte mechanisch verbunden, dass das elektronische Bauelement sich nicht von der Oberfläche der Leiterplatte lösen bzw. wegbewegen oder entlang der Oberfläche der Leiterplatte bewegen kann.

Erfindungsgemäß weist das elektronische Bauelemente eine Trennwand zwischen den zwei Kontaktflächen auf, wobei das Vergussmaterial derart zwischen der Trennwand und der Oberfläche der Leiterplatte angeordnet ist, dass die zwei Verbindungselemente in zwei voneinander durch die Trennwand abgetrennten Kammern angeordnet sind. Vorteilhaft hieran ist, dass das Entstehen eines Kurzschlusses zwischen den beiden Verbindungselementen (z.B. durch einen Metallspan oder ähnliches) in der Regel technisch einfach und sicher verhindert wird.

Gemäß einer Ausführungsform des Verfahrens weist das elektronische Bauelement einen Positionierstift zum Ausrichten des elektronischen Bauelements relativ zu der Leiterplatte und die Leiterplatte eine zu dem Positionierstift komplementäre Aussparung zum Aufnehmen des Positionierstifts auf, und das elektronische Bauelement wird derart auf der Oberfläche der Leiterplatte angeordnet, dass der Positionierstift zumindest teilweise in der Aussparung angeordnet ist. Hierdurch wird typischerweise technisch einfach eine Ausrichtung des elektronischen Bauelements relativ zu der Leiterplatte erreicht. Zudem wird hierdurch in der Regel ein Verrutschen des elektronischen Bauelements auf der Oberfläche der Leiterplatte oder parallel hierzu im Wesentlichen ausgeschlossen.

Erfindungsgemäß weist das Verfahren ferner folgende Schritte nach dem Anordnen des elektronischen Bauelements auf der Oberfläche der Leiterplatte auf: Aufbringen eines flüssigen Vergussmaterials auf die Oberfläche der Leiterplatte derart, dass das Vergussmaterial zumindest einen Teil der Oberfläche der Leiterplatte, einen Teil des elektronischen Bauelements und einen Teil des Verbindungselements flüssigkeitsdicht mit einer Vergussmasse bedeckt; und Aushärten des Vergussmaterials. Hierdurch wird im Allgemeinen die elektrische Verbindung zwischen dem Verbindungselement bzw. den Verbindungselementen und der Leiterplatte technisch einfach vor Öl bzw. Getriebeöl geschützt. Zudem wird hierdurch in der Regel das elektronische Bauelement derart mit der Leiterplatte mechanisch verbunden, dass das elektronische Bauelement sich nicht von der Oberfläche der Leiterplatte lösen bzw. wegbewegen oder entlang der Oberfläche der Leiterplatte bewegen kann.

Erfindungsgemäß sind auf der Leiterplatte zwei mit der Leiterplatte elektrisch und mechanisch, insbesondere mittels einer Lötverbindung, vorzugsweise einer Reflow-Lötverbindung, verbundene Verbindungselemente angeordnet, und das elektronische Bauelement wird derart auf der Leiterplatte angeordnet, dass die beiden Verbindungselemente jeweils mit einer Kontaktfläche des elektronischen Bauelements elektrisch verbunden sind, wobei das elektronische Bauelement eine Trennwand aufweist, wobei das elektronische Bauelement derart auf der Oberfläche der Leiterplatte angeordnet wird, dass die Trennwand zwischen den beiden Verbindungselementen angeordnet ist, und wobei das Vergussmaterial derart auf die Oberfläche der Leiterplatte aufgebracht wird, dass durch das Vergussmaterial und die Trennwand die beiden Verbindungselementen in zwei voneinander durch die Trennwand abgetrennten Kammern angeordnet sind. Vorteilhaft hieran ist, dass das elektronische Bauelement typischerweise noch sicherer mit der Leiterplatte elektrisch verbunden wird. Insbesondere weisen somit beide Pole des elektronischen Bauelements eine elektrische Verbindung mit der Leiterplatte über federnd ausgebildete Verbindungselemente auf, so dass in der Regel Bauhöhenunterschiede und/oder Bautoleranzen und/oder unterschiedliche Wärmeausdehnungen besonders gut ausgeglichen werden können. Zudem ist vorteilhaft, dass das Entstehen eines Kurzschlusses zwischen den beiden Verbindungselementen (z.B. durch einen Metallspan oder ähnliches) typischerweise technisch einfach und sicher verhindert wird.

Es wird darauf hingewiesen, dass einige der möglichen Merkmale und Vorteile der Erfindung hierin mit Bezug auf unterschiedliche Ausführungsformen des elektronischen Steuermoduls bzw. des Verfahrens zum Herstellen eines elektronischen Steuermoduls beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine perspektivische Ansicht einer Leiterplatte einer Ausführungsform des erfindungsgemäßen elektronischen Steuermoduls;
- Fig. 2 zeigt: die Leiterplatte und das elektronische Bauelement vor dem Anordnen des elektronischen Bauelements auf der Leiterplatte;
- Fig. 3 zeigt: eine Querschnittsansicht des elektronischen Bauelements;
- Fig. 4 zeigt: eine Querschnittsansicht einer Ausführungsform des erfindungsgemäßen elektronischen Steuermoduls vor dem Aufbringen von Vergussmaterial;
- Fig. 5 zeigt: eine Querschnittsansicht einer Ausführungsform des erfindungsgemäßen elektronischen Steuermoduls nach dem Aufbringen von Vergussmaterial;
- Fig. 6 zeigt: eine Aufsicht auf einen Teil des elektronischen Steuermoduls aus Fig. 5; und
- Fig. 7 zeigt: eine um 90° um eine vertikale Achse gedrehte Querschnittsansicht des elektronischen Steuermoduls aus Fig. 6 entlang der Linie VII-VII.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

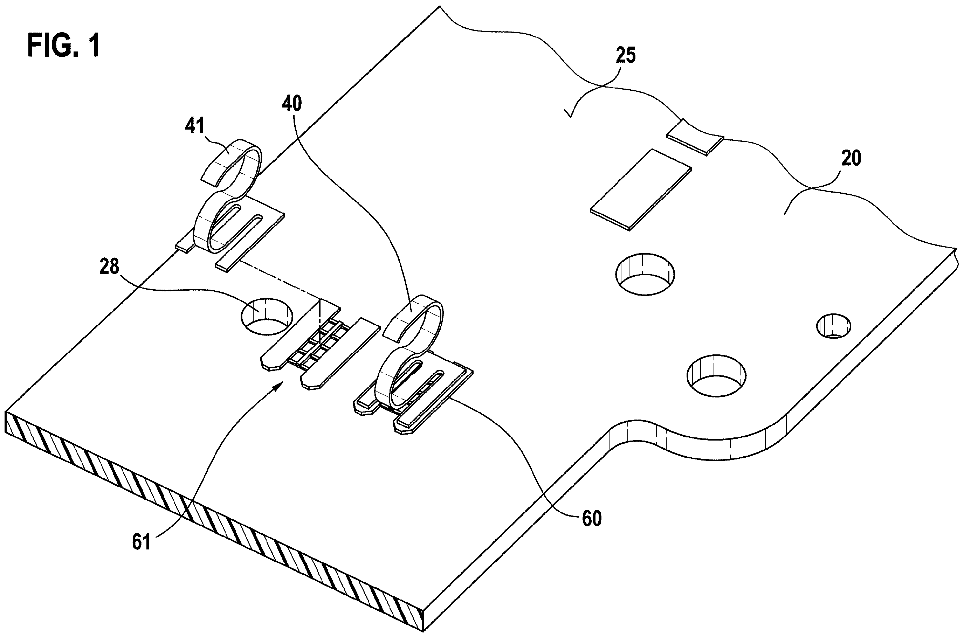

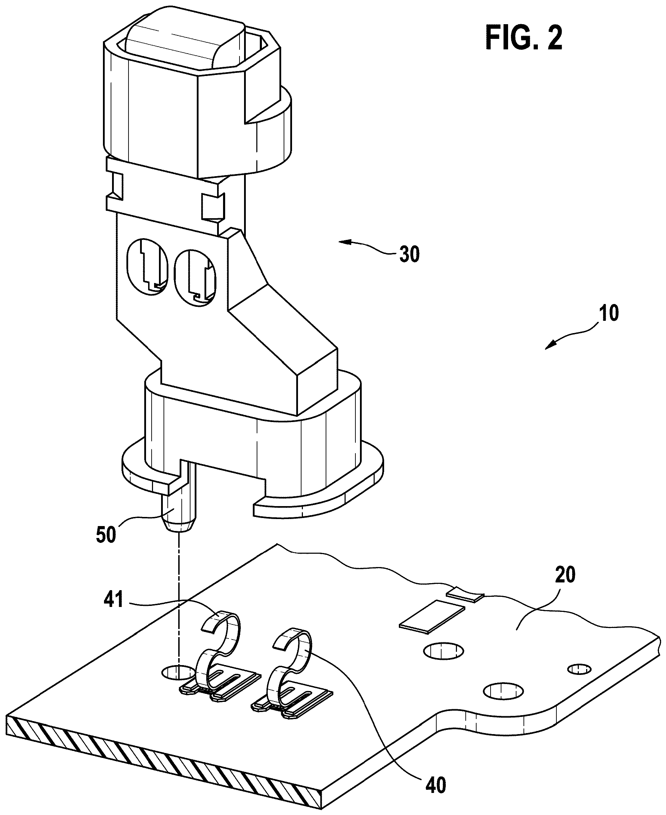

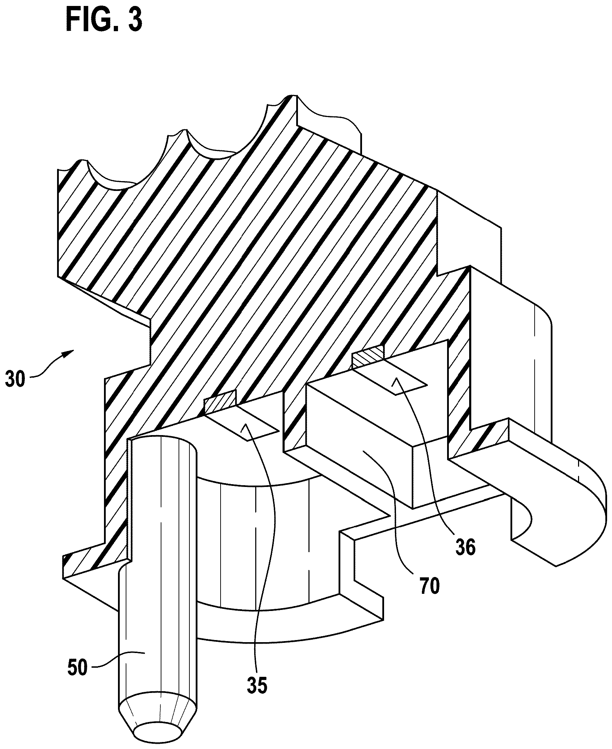

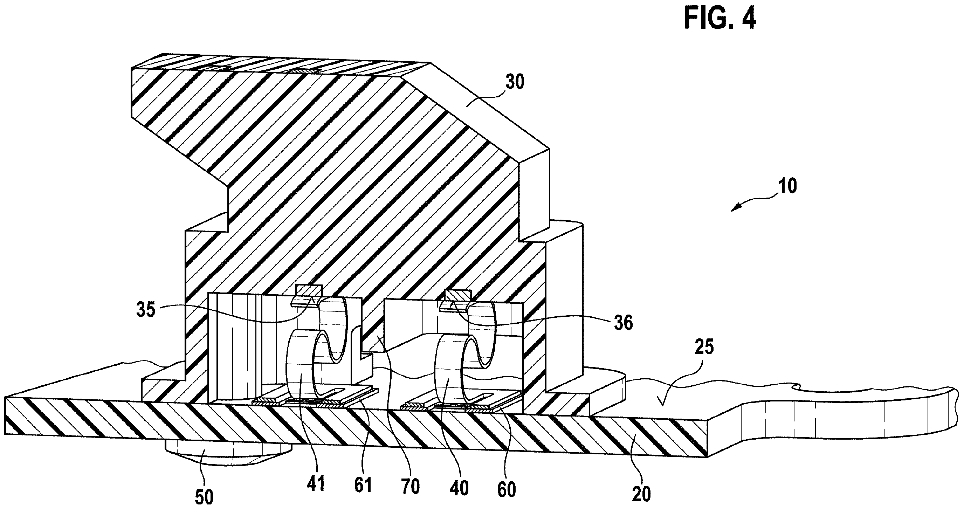

Fig. 1 zeigt eine perspektivische Ansicht einer Leiterplatte 20 einer Ausführungsform des erfindungsgemäßen elektronischen Steuermoduls 10. Fig. 2 zeigt die Leiterplatte 20 und das elektronische Bauelement 30 vor dem Anordnen des elektronischen Bauelements 30 auf der Leiterplatte 20. Fig. 3 zeigt eine Querschnittsansicht des elektronischen Bauelements 30. Fig. 4 zeigt eine Querschnittsansicht einer Ausführungsform des erfindungsgemäßen elektronischen Steuermoduls 10 vor dem Aufbringen von Vergussmaterial 80.

Das elektronische Steuermodul 10 umfasst eine Leiterplatte 20 und ein elektronisches Bauelement 30, z.B. einen Sensor. Der Sensor kann z.B. Drehzahlen und/oder Positionen von Zahnrändern und/oder Schaltelementen, insbesondere in Getrieben, erfassen. Das elektronische Steuermodul 10 kann insbesondere ein Steuerungsmodul für ein Getriebe sein, das in dem mit einem Getriebeöl gefüllten Hohlraum des Getriebes angeordnet ist bzw. wird.

Auf der Leiterplatte 20 sind zwei Verbindungselemente 40, 41 angeordnet. Die Verbindungselemente 40, 41 sind über Reflow-Lötpads 60, 61 bzw. Reflow-Löten elektrisch und mechanisch mit der Leiterplatte 20 verbunden. In Fig. 1 ist das linke Verbindungselement 40, 41 noch nicht auf dem Lötpad 60, 61 angeordnet. Der Weg des linken Verbindungselements 40, 41 zu seiner endgültigen Position ist durch eine gestrichelte Linie dargestellt.

Die Verbindungselemente 40, 41 sind jeweils federnd ausgebildet, so dass sie in einer Richtung, die senkrecht zur Oberfläche 25 der Leiterplatte 20 verläuft (in Fig. 1 nach oben bzw. nach unten) federnd, d.h. reversibel nachgebend, ausgebildet sind.

Die Verbindungselemente 40, 41 sind jeweils als sogenannte S-Feder ausgebildet. Der obere Endbereich des jeweiligen Verbindungselements 40, 41 verläuft im Wesentlichen parallel zu der Oberfläche 25 der Leiterplatte 20. Neben den Verbindungselementen 40, 41 ist eine Aussparung 28 der Leiterplatte 20 angeordnet, die durch die Leiterplatte 20 von der Oberfläche 25 der Leiterplatte 20 bis zur Rückseite 26 der Leiterplatte 20 verläuft. Die Aussparung 28 dient zum Aufnehmen eines Positionierstifts 50 des elektronischen Bauelements 30.

Durch die S-Feder sind die Verbindungselemente 40, 41 auch in Richtungen parallel zu der Oberfläche 25 der Leiterplatte 20 beweglich bzw. federnd ausgebildet. In diese Richtungen ist jedoch das jeweilige Verbindungselement 40, 41 in der Regel weniger federnd bzw. kann weniger weit reversibel, ausgelenkt werden als in die Richtung senkrecht zur Oberfläche 25 der Leiterplatte 20.

Das elektronische Bauelement 30 umfasst ein Gehäuse, das das eigentliche elektronische Bauelement 30, z.B. einen Sensor, eine elektronische Schaltung oder ähnliches, teilweise oder vollständig umgibt. Das elektronische Bauelement 30 weist zwei Kontaktflächen 35, 36 zum elektrischen Verbinden des elektronischen Bauelements 30 mit den Verbindungselementen 40, 41 bzw. der Leiterplatte 20 auf.

Das elektronische Bauelement 30 wird auf die Oberfläche 25 der Leiterplatte 20 gesetzt bzw. auf dieser derart angeordnet, dass die beiden Kontaktflächen 35, 36 jeweils ein Verbindungselement 40, 41 kontaktieren bzw. berühren. Insbesondere berührt die Kontaktfläche 35, 36 das jeweilige obere Ende der S-Feder. Die Bewegung des elektronischen Bauelements 30 beim Aufsetzen auf die Oberfläche 25 der Leiterplatte 20 ist in Fig. 2 mit einer gestrichelten Linie dargestellt. Bei dem Aufsetzen auf die Oberfläche 25 der Leiterplatte 20 wird das jeweilige Verbindungselement 40, 41 bzw. die S-Feder zusammengedrückt. Durch die federnde Ausbildung des Verbindungselements 40, 41 bzw. durch das Zusammendrücken können Toleranzen des Bauelements 30 senkrecht zur Oberfläche 25 der Leiterplatte 20 ausgeglichen werden. Auch Toleranzen parallel zu der Oberfläche 25 der Leiterplatte 20 können durch die Verbindungselemente 40, 41 ausgeglichen werden.

Das obere Endstück des jeweiligen Verbindungselements 40, 41 kontaktiert jeweils die Kontaktfläche 35, 36 des elektronischen Bauelements 30, wie dies in Fig. 4 zu sehen ist. Das Verbindungselement 40, 41 und die Kontaktfläche 35, 36 sind mechanisch nicht fest miteinander verbunden (z.B. gelötet, geschweißt, verklebt oder ähnliches), sondern das Verbindungselement 40, 41 liegt aufgrund der Federkraft des Verbindungselements 40, 41 teilweise auf der Kontaktfläche 35, 36 auf bzw. an der Kontaktfläche 35, 36 an.

Das elektronische Bauelement 30 weist einen Positionierstift 50 auf, der von einer Ebene, in der die Kontaktflächen 35, 36 angeordnet sind, senkrecht absteht. Der Positionierstift 50 dient zum Ausrichten des elektronischen Bauelements 30 in einer erste Richtung und eine zweite zu der ersten Richtung senkrechte Richtung, wobei die erste Richtung und die zweite Richtung parallel zu der Oberfläche 25 der Leiterplatte 20. Wenn der Positionierstift 50 zumindest teilweise in der Aussparung 28 angeordnet ist, kann das elektronische Bauelement 30 nicht mehr verschoben, sondern lediglich um den Positionierstift 50 als Achse gedreht werden.

Zum Ausrichten des elektronischen Bauelements 30 relativ zu der Leiterplatte 20 kann auch eine vorgegebene Fläche bzw. Kante des elektronischen Bauelements 30 parallel zu einer Kante der Leiterplatte 20 ausgerichtet werden. Somit ist das elektronische Bauelement 30 auch in der Richtung um den Positionierstift 50 als Achse herum ausgerichtet.

Denkbar ist auch, dass anstelle des Ausrichtens einer Fläche bzw. Kante des elektronischen Bauelements 30 zu einer Kante der Leiterplatte 20 das elektronische Bauelement 30 einen zweiten Positionierstift 50 und die Leiterplatte 20 eine zweite Aussparung 28 aufweist, wobei beim Anordnen des elektronischen Bauelements 30 auf der Oberfläche 25 der Leiterplatte 20 der zweite Positionierstift 50 in die zweite Aussparung 28 eingeführt wird.

Zum Ausrichten in einer dritten Richtung, die senkrecht zu der ersten Richtung und senkrecht zu der zweiten Richtung verläuft, weist das elektronische Bauelement 30 eine Anschlagsfläche auf, die die Oberfläche 25 der Leiterplatte 20 kontaktiert, wenn das elektronische Bauelement 30 in der richtigen Position in der dritten Richtung angeordnet ist.

Der Positionierstift 50 ist komplementär zu der Aussparung 28 der Leiterplatte 20 ausgebildet. Beispielsweise können der Positionierstift 50 und die Aussparung 28 jeweils einen kreisrunden Querschnitt aufweisen. Möglich ist auch ein elliptischer Querschnitt, der eine noch bessere Ausrichtung ermöglicht.

Beim Aufsetzen des elektronischen Bauelements 30 auf die Oberfläche 25 der Leiterplatte 20 wird der Positionierstift 50 derart in die Aussparung 28 der Leiterplatte 20 eingeführt, dass der Positionierstift 50 über die Rückseite 26 der Leiterplatte 20 hinaussteht.

Nach dem Aufsetzen des elektronischen Bauelements 30 auf die Oberfläche 25 der Leiterplatte 20 und dem Ausrichten des elektronischen Bauelements 30 relativ zu der Leiterplatte 20 wird der über die Rückseite 26 der Leiterplatte 20 hinausstehende Teil des Positionierstifts 50 wärmeverstemmt, d.h. der über die Rückseite 26 der Leiterplatte 20 hinausstehende Teil des Positionierstifts 50 wird flachgedrückt, so dass der zuvor über die Rückseite 26 der Leiterplatte 20 hinausstehende Teil des Positionierstifts 50 anschließend flächig auf der Rückseite 26 der Leiterplatte 20 aufliegt. Dies kann z.B. durch einen warmen Stempel, einen kalten Stempel und/oder durch Heißluft durchgeführt werden.

Nun ist die Position des elektronischen Bauelements 30 in einer Richtung senkrecht zur Oberfläche 25 der Leiterplatte 20 festgelegt, so dass der Positionierstift 50 nicht mehr aus der Aussparung 28 heraus bewegt werden kann. Zudem ist auch eine Bewegung des elektronischen Bauelements 30 parallel zu der Oberfläche 25 der Leiterplatte 20 nicht mehr möglich. Insbesondere ist auch ein Drehen um den Positionierstift 50 nicht mehr möglich.

Fig. 4 zeigt den Zustand nach diesen Schritten.

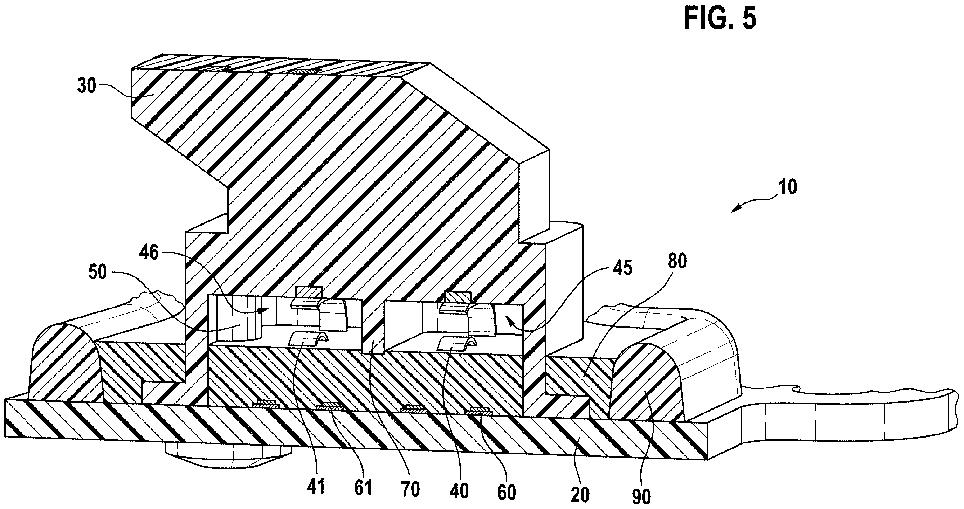

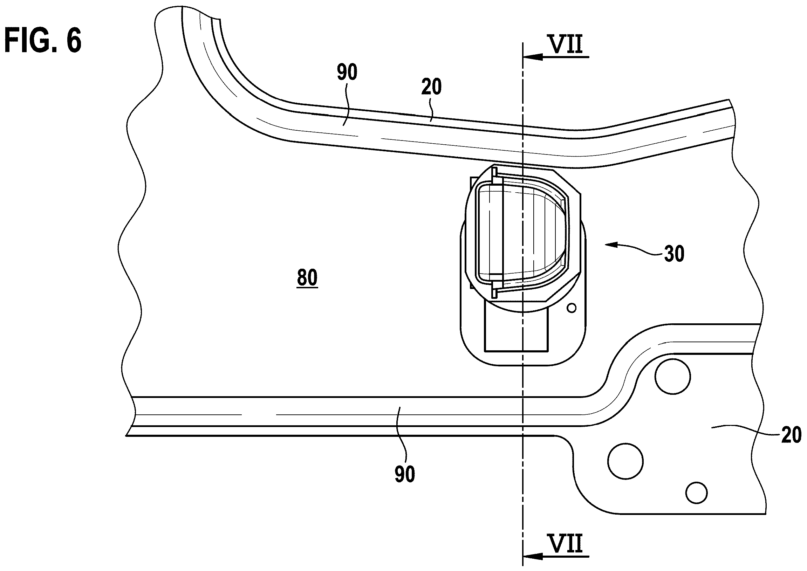

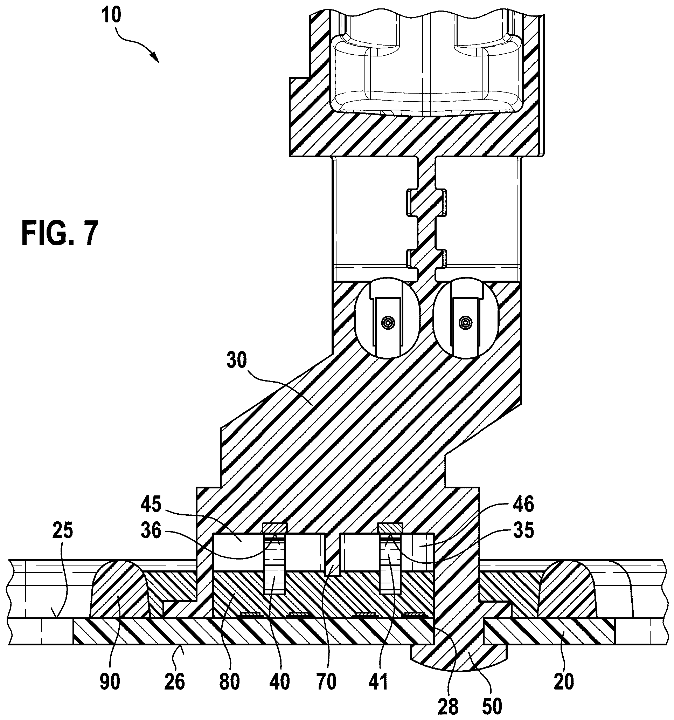

Fig. 5 zeigt eine Querschnittsansicht einer Ausführungsform des erfindungsgemäßen elektronischen Steuermoduls 10 nach dem Aufbringen von Vergussmaterial 80. Fig. 6 zeigt eine Aufsicht auf einen Teil des elektronischen Steuermoduls 10 aus Fig. 5. Fig. 7 zeigt eine Querschnittsansicht des elektronischen Steuermoduls 10 aus Fig. 6 entlang der Linie VII-VII. Die Querschnittsansicht der Fig. 7 ist um 90° um eine vertikale Achse gegenüber der Ansicht gedreht, die sich bei einer Ansicht auf die Ebene VII-VII ergeben würde.

Nach dem Wärmeverstemmen wird ein Vergussmaterial 80 in flüssiger oder verflüssigter Form auf einen Teil der Oberfläche 25 der Leiterplatte 20 aufgebracht und anschließend ausgehärtet. Zuvor kann ein Rand bzw. ein Wall 90 auf die Oberfläche 25 der Leiterplatte 20 aufgebracht worden sein, um ein Wegfließen bzw. Zerfließen des Vergussmaterials 80 vor dem Aushärten zu verhindern.

Das Vergussmaterial 80 bedeckt nicht nur einen Teil der Oberfläche 25 der Leiterplatte 20, sondern auch einen Teil der Verbindungselemente 40, 41 und einen vorstehenden Rand des Gehäuses des elektronischen Bauelements 30 (sogenannte Hutkrempe), wobei der vorstehende Rand Teil der Anschlagfläche sein kann. In Fig. 5 ist besonders gut zu erkennen, dass eine Hutkrempe des elektronischen Bauelements 30 von dem Vergussmaterial 80 bedeckt ist.

Das Vergussmaterial 80 (z.B. ein Kunststoff) schützt die jeweilige Verbindung zwischen den Verbindungselementen 40, 41 und der Leiterplatte 20 vor Metallspänen und aggressiven Flüssigkeiten, z.B. Getriebeöl.

Von den Verbindungselementen 40, 41 steht jeweils ein oberer Teil (d.h. der der Oberfläche 25 der Leiterplatte 20 abgewandte Teil) aus dem Vergussmaterial 80 hervor, d.h. ein oberer Teil des jeweiligen Verbindungselements 40, 41 ist nicht von dem Vergussmaterial 80 bedeckt. Der obere Endbereich des jeweiligen Verbindungselements 40, 41, der parallel zu der Oberfläche 25 der Leiterplatte 20 verläuft und der von der Leiterplatte 20 am weitesten entfernt ist, ist nicht von dem Vergussmaterial 80 bedeckt bzw. eingeschlossen und ist somit noch flexibel bzw. federnd.

Hierdurch können auch nach dem Vergießen mit Vergussmaterial 80 bei Temperaturänderungen die unterschiedlichen Ausdehnungen bzw. Größenänderungen der unterschiedlichen Elemente (Vergussmaterial 80, Leiterplatte 20, Reflow-Lötpad 60, 61, elektronisches Bauelement 30), die durch unterschiedliche Wärmeausdehnungskoeffizienten der unterschiedlichen Materialien entstehen, ausgeglichen werden. Somit ist die elektrische Verbindung des elektronischen Bauelements 30 mit der Leiterplatte 20 besonders (wärme)stabil.

Insbesondere durch die zwei grundsätzlich voneinander verschiedenen Arten der Verbindung zwischen Verbindungselement 40, 41 und Leiterplatte 20 (Reflow-Löten) einerseits und der Verbindung zwischen Verbindungselement 40, 41 und elektronischem Bauelement 30 (Drücken des federnden Elements gegen eine Kontaktfläche 35, 36) andererseits ist das elektronische Steuermodul 10 gegenüber Temperaturänderungen besonders stabil.

Das elektronische Bauelement 30 weist auf einer der Leiterplatte 20 zugewandten Seite eine Trennwand 70 auf, die in Fig. 5 senkrecht zur Oberfläche 25 der Leiterplatte 20 verläuft. Die Trennwand 70 ist zwischen den beiden Kontaktflächen 35, 36 des elektronischen Bauelements 30 angeordnet. Das Vergussmaterial 80 wird in einer derartigen Höhe auf die Oberfläche 25 der Leiterplatte 20 aufgebraucht, dass der Bereich zwischen der Trennwand 70 und der Oberfläche 25 der Leiterplatte 20 (spätestens nach dem Aushärten des Vergussmaterials 80) mit Vergussmaterial 80 gefüllt ist. Hierdurch entstehen zwei Kammern 45, 46, die durch die Trennwand 70 voneinander getrennt sind. Jedes Verbindungselement 40, 41 bzw. jede Kontaktfläche 35, 36 ist somit in einer eigenen Kammer 45, 46 angeordnet. Somit können Metallspäne keinen Kurzschluss zwischen den beiden Kontaktflächen 35, 36 bzw. Verbindungselementen 40, 41 herstellen, da die Trennwand 70 dies physisch verhindert. Die Kammern 45, 46 sind zur Umgebung hin teilweise offen ausgebildet, d.h. Getriebeöl oder ähnliches kann von außen in die Kammern 45, 46 eindringen.

Die Kontaktflächen 35, 36 des elektronischen Bauelements 30 und zumindest der Teil der Verbindungselemente 40, 41, die aus dem Vergussmaterial 80 hervorstehen, weisen entsprechende Beschichtungen (z.B. Gold und/oder Zinn) auf, so dass diese nicht durch das Getriebeöl korrodieren.

Die Leiterplatte 20 kann z.B. ein printed circuit board (PCB) sein.

Die Position der Verbindungselemente 40, 41 auf der Oberfläche 25 der Leiterplatte 20 kann bereits beim Festlegen des Layouts der Leiterplatte 20 durch Festlegen der Reflow-Lötpads 60, 61 festgelegt werden. Durch die Abstimmung der Geometrien der Lötpads 60, 61 und der Verbindungsflächen zwischen dem jeweiligen Verbindungselement 40, 41 und dem jeweiligen Lötpad 60, 61 zentrieren sich die Verbindungselemente 40, 41 auf den Lötpads 60, 61 während des Reflow-Lötens. Somit können die Verbindungselemente 40, 41 mit einer geringen Positionsabweichung auf der Leiterplatte 20 fixiert und elektrisch kontaktiert werden.

Die elektronischen Bauelemente 30 können zueinander sehr unterschiedliche Bauhöhen aufweisen. Das Anordnen des elektronischen Bauelements 30 auf der Leiterplatte 20 kann erst kurz vor dem Ende eines Prozessflusses bzw. kurz vor dem Vergießen mit Vergussmaterial 80 stattfinden. Hierdurch können vor dem Anordnen des elektronischen Bauelements 30 auf der Leiterplatte 20 standardisierte Einrichtungen bzw. Vorrichtung und/oder Werkzeuge verwendet werden.

Das elektronische Steuermodul 10 kann insbesondere eine Getriebesteuermodul sein bzw. umfassen.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Elektronisches Steuermodul (10), insbesondere für eine Getriebesteuerung, umfassend
eine Leiterplatte (20), und
mindestens ein elektronisches Bauelement (30), insbesondere ein Sensorelement,
wobei auf der Leiterplatte (20) mindestens ein in einer Richtung, die senkrecht zu einer Oberfläche (25) der Leiterplatte (20) verläuft, federnd ausgebildetes Verbindungselement (40, 41) zum elektrischen Verbinden des elektronischen Bauelements (30) mit der Leiterplatte (20) angeordnet ist, wobei das Verbindungselement (40, 41) mit der Leiterplatte (20), insbesondere mittels einer Lötverbindung, vorzugsweise einer Reflow-Lötverbindung, elektrisch und mechanisch verbunden ist,
wobei das elektronische Bauelement (30) über jeweils eine Kontaktfläche (35, 36) mit dem Verbindungselement (40, 41) elektrisch verbunden ist, **dadurch gekennzeichnet, dass** zumindest ein Teil der Oberfläche (25) der Leiterplatte (20), ein Teil des elektronischen Bauelements (30) und ein Teil des Verbindungselements (40, 41) oder der Verbindungselemente (40, 41) flüssigkeitsdicht mit einem Vergussmaterial (80) vergossen sind und das elektronische Bauelement (30) eine Trennwand (70) zwischen zwei Kontaktflächen (35, 36) aufweist, wobei das Vergussmaterial (80) derart zwischen der Trennwand (70) und der Oberfläche (25) der Leiterplatte (20) angeordnet ist, dass zwei Verbindungselemente (40, 41) in zwei voneinander durch die Trennwand (70) abgetrennten Kammern (45, 46) angeordnet sind.

2. Elektronisches Steuermodul (10) nach Anspruch 1, wobei auf der Leiterplatte (20) zwei Verbindungselemente (40, 41) zum elektrischen Verbinden des elektronischen Bauelements (30) mit der Leiterplatte (20) angeordnet sind, wobei jedes Verbindungselement (40, 41) mit der Leiterplatte (20), insbesondere mittels Löten, vorzugsweise mittels Reflow-Löten, elektrisch und mechanisch verbunden ist, und wobei das elektronische Bauelement (30) jeweils über eine Kontaktfläche (35, 36) mit den Verbindungselementen (40, 41) elektrisch verbunden ist.

3. Elektronisches Steuermodul (10) nach Anspruch 1 oder 2, wobei das elektronische Bauelement (30) einen Positionierstift (50) zum Ausrichten des elektronischen Bauelements (30) relativ zu der Leiterplatte (20) umfasst, und
die Leiterplatte (20) eine zu dem Positionierstift (50) komplementäre Aussparung (28) zum Aufnehmen des Positionierstifts (50) aufweist, wobei der Positionierstift (50) zumindest teilweise in der Aussparung (28) angeordnet ist.

4. Elektronisches Steuermodul (10) nach Anspruch 3, wobei ein flachgedrückter Teil des Positionierstifts (50) zum Befestigen des elektronischen Bauelements (30) an der Leiterplatte (20) auf einer der Oberfläche (25) der Leiterplatte (20) gegenüberliegenden Rückseite (26) der Leiterplatte (20) aufliegt.

5. Verfahren zum Herstellen eines elektronischen Steuermoduls (10), insbesondere eines elektronischen Steuermoduls (10) nach einem der vorhergehenden Ansprüche,
wobei das Verfahren folgende Schritte umfasst:
Bereitstellen einer Leiterplatte (20) mit mindestens einem mit der Leiterplatte (20) elektrisch und mechanisch, insbesondere mittels einer Lötverbindung, vorzugsweise einer Reflow-Lötverbindung, verbundenen Verbindungselement (40, 41), wobei das Verbindungselement (40, 41) in einer Richtung, die senkrecht zu einer Oberfläche (25) der Leiterplatte (20) ausgebildet ist, federnd ausgebildet ist;
Bereitstellen eines elektronischen Bauelements (30) mit mindestens einer Kontaktfläche (35, 36) zum elektrischen Verbinden des elektronischen Bauelements (30); und
Anordnen des elektronischen Bauelements (30) auf der Oberfläche (25) der Leiterplatte (20) derart, dass die Kontaktfläche (35, 36) des elektronischen Bauelements (30) das Verbindungselement (40, 41) zum Herstellen einer elektrischen Verbindung zwischen dem elektronischen Bauelement (30) und der Leiterplatte (20) kontaktiert,
wobei das Verfahren ferner folgende Schritte nach dem Anordnen des elektronischen Bauelements (30) auf der Oberfläche (25) der Leiterplatte (20) aufweist:
Aufbringen eines flüssigen Vergussmaterials (80) auf die Oberfläche (25) der Leiterplatte (20) derart, dass das Vergussmaterial (80) zumindest einen Teil der Oberfläche (25) der Leiterplatte (20), einen Teil des elektronischen Bauelements (30) und einen Teil des Verbindungselements (40, 41) flüssigkeitsdicht mit einer Vergussmasse bedeckt; und
Aushärten des Vergussmaterials (80), wobei auf der Leiterplatte (20) zwei mit der Leiterplatte (20) elektrisch und mechanisch, insbesondere mittels einer Lötverbindung, vorzugsweise einer Reflow-Lötverbindung, verbundene Verbindungselemente (40, 41) angeordnet sind, und das elektronische Bauelement (30) derart auf der Leiterplatte (20) angeordnet wird, dass die beiden Verbindungselemente (40, 41) jeweils mit einer Kontaktfläche (35, 36) des elektronischen Bauelements (30) elektrisch verbunden sind, wobei das elektronische Bauelement (30) eine Trennwand (70) aufweist, wobei das elektronische Bauelement (30) derart auf der Oberfläche (25) der Leiterplatte (20) angeordnet wird, dass die Trennwand (70) zwischen den beiden Verbindungselementen (40, 41) angeordnet ist,
und wobei das Vergussmaterial (80) derart auf die Oberfläche (25) der Leiterplatte (20) aufgebracht wird, dass durch das Vergussmaterial (80) und die Trennwand (70) die beiden Verbindungselementen (40, 41) in zwei voneinander durch die Trennwand (70) abgetrennten Kammern (45, 46) angeordnet sind..

6. Verfahren nach Anspruch 5, wobei
das elektronische Bauelement (30) einen Positionierstift (50) zum Ausrichten des elektronischen Bauelements (30) relativ zu der Leiterplatte (20) und die Leiterplatte (20) eine zu dem Positionierstift (50) komplementäre Aussparung (28) zum Aufnehmen des Positionierstifts (50) aufweist, und wobei das elektronische Bauelement (30) derart auf der Oberfläche (25) der Leiterplatte (20) angeordnet wird, dass der Positionierstift (50) zumindest teilweise in der Aussparung (28) angeordnet ist.

## Claims

1. Electronic control module (10), in particular for a transmission controller, comprising
a printed circuit board (20), and
at least one electronic component (30), in particular a sensor element,
wherein at least one connecting element (40, 41), which is resilient in a direction which runs perpendicularly to a surface (25) of the printed circuit board (20), for electrically connecting the electronic component (30) to the printed circuit board (20) is arranged on the printed circuit board (20), wherein the connecting element (40, 41) is electrically and mechanically connected to the printed circuit board (20), in particular by means of a solder connection, preferably a reflow solder connection, wherein the electronic component (30) is electrically connected to the connecting element (40, 41) via a contact area (35, 36) in each case, **characterized in that** at least one portion of the surface (25) of the printed circuit board (20), one portion of the electronic component (30) and one portion of the connecting element (40, 41) or of the connecting elements (40, 41) are potted in a fluid-tight manner with a potting material (80) and the electronic component (30) has a separating wall (70) between two contact areas (35, 36), wherein the potting material (80) is arranged between the separating wall (70) and the surface (25) of the printed circuit board (20) in such a way that two connecting elements (40, 41) are arranged in two chambers (45, 46) which are separated from each other by the separating wall (70).

2. Electronic control module (10) according to Claim 1, wherein
two connecting elements (40, 41) for electrically connecting the electronic component (30) to the printed circuit board (20) are arranged on the printed circuit board (20), wherein each connecting element (40, 41) is electrically and mechanically connected to the printed circuit board (20), in particular by means of soldering, preferably by means of reflow soldering, and wherein the electronic component (30) is electrically connected to the connecting elements (40, 41) via a contact area (35, 36) in each case.

3. Electronic control module (10) according to Claim 1 or 2, wherein
the electronic component (30) comprises a positioning pin (50) for orienting the electronic component (30) relative to the printed circuit board (20), and
the printed circuit board (20) has a cutout (28), which complements the positioning pin (50), for receiving the positioning pin (50), wherein the positioning pin (50) is at least partially arranged in the cutout (28).

4. Electronic control module (10) according to Claim 3, wherein
a pressed-flat portion of the positioning pin (50) for fastening the electronic component (30) to the printed circuit board (20) rests on a rear side (26) of the printed circuit board (20), the rear side being situated opposite the surface (25) of the printed circuit board (20) .

5. Method for producing an electronic control module (10), in particular an electronic control module (10) according to any of the preceding claims,
wherein the method comprises the following steps:
providing a printed circuit board (20) having at least one connecting element (40, 41) which is electrically and mechanically connected, in particular by means of a solder connection, preferably a reflow solder connection, to the printed circuit board (20), wherein the connecting element (40, 41) is resilient in a direction which is perpendicular to a surface (25) of the printed circuit board (20);
providing an electronic component (30) having at least one contact area (35, 36) for electrically connecting the electronic component (30); and
arranging the electronic component (30) on the surface (25) of the printed circuit board (20) in such a way that the contact area (35, 36) of the electronic component (30) makes contact with the connecting element (40, 41) for establishing an electrical connection between the electronic component (30) and the printed circuit board (20),
wherein the method further comprises the following steps after the electronic component (30) is arranged on the surface (25) of the printed circuit board (20):
applying a liquid potting material (80) to the surface (25) of the printed circuit board (20) in such a way that the potting material (80) covers at least one portion of the surface (25) of the printed circuit board (20), one portion of the electronic component (30) and one portion of the connecting element (40, 41) in a liquid-tight manner with a potting compound; and
curing the potting material (80), wherein two connecting elements (40, 41), which are electrically and mechanically connected, in particular by means of a solder connection, preferably a reflow solder connection, to the printed circuit board (20) are arranged on the printed circuit board (20), and the electronic component (30) is arranged on the printed circuit board (20) in such a way that the two connecting elements (40, 41) are each electrically connected to a contact area (35, 36) of the electronic component (30),
wherein the electronic component (30) has a separating wall (70), wherein the electronic component (30) is arranged on the surface (25) of the printed circuit board (20) in such a way that the separating wall (70) is arranged between the two connecting elements (40, 41), and wherein the potting material (80) is applied to the surface (25) of the printed circuit board (20) in such a way that, owing to the potting material (80) and the separating wall (70), the two connecting elements (40, 41) are arranged in two chambers (45, 46) which are separated from each other by the separating wall (70).

6. Method according to Claim 5, wherein
the electronic component (30) has a positioning pin (50) for orienting the electronic component (30) relative to the printed circuit board (20) and the printed circuit board (20) has a cutout (28), which complements the positioning pin (50), for receiving the positioning pin (50), and wherein the electronic component (30) is arranged on the surface (25) of the printed circuit board (20) in such a way that the positioning pin (50) is at least partially arranged in the cutout (28).

## Revendications

1. Module de commande électronique (10), notamment pour une commande de transmission, comprenant
une carte à circuit imprimé (20), et
au moins un composant électronique (30), notamment un élément de détection,
au moins un élément de connexion (40, 41) conçu de manière élastique dans une direction qui s'étend perpendiculairement à une surface (25) de la carte à circuit imprimé (20) étant agencé sur la carte à circuit imprimé (20) de façon à connecter électriquement le composant électronique (30) à la carte à circuit imprimé (20), l'élément de connexion (40, 41) étant relié électriquement et mécaniquement à la carte à circuit imprimé (20), en particulier au moyen d'une connexion par brasage, de préférence une connexion par brasage par refusion, le composant électronique (30) étant connecté électriquement à l'élément de connexion (40, 41) par l'intermédiaire d'une surface de contact respective (35, 36), **caractérisé en ce qu'**au moins une partie de la surface (25) de la carte à circuit imprimé (20), une partie du composant électronique (30) et une partie de l'élément de connexion (40, 41) ou des éléments de connexion (40, 41) sont encapsulées de manière étanche aux liquides au moyen d'un matériau d'encapsulation (80) et le composant électronique (30) comporte une paroi de séparation (70) entre deux surfaces de contact (35, 36), le matériau d'encapsulation (80) étant agencé entre la paroi de séparation (70) et la surface (25) de la carte à circuit imprimé (20) de telle sorte que deux éléments de connexion (40, 41) soient agencés dans deux chambres (45, 46) séparées l'une de l'autre par la paroi de séparation (70).

2. Module de commande électronique (10) selon la revendication 1, dans lequel
deux éléments de connexion (40, 41) sont agencés sur la carte à circuit imprimé (20) de façon à connecter électriquement le composant électronique (30) à la carte à circuit imprimé (20), chaque élément de connexion (40, 41) étant connecté électriquement et mécaniquement à la carte à circuit imprimé (20), notamment par brasage, de préférence par brasage par refusion, et le composant électronique (30) étant connecté électriquement aux éléments de connexion (40, 41) respectivement par une surface de contact (35, 36).

3. Module de commande électronique (10) selon la revendication 1 ou la revendication 2, dans lequel
le composant électronique (30) comprend une broche de positionnement (50) pour orienter le composant électronique (30) par rapport à la carte à circuit imprimé (20), et
la carte à circuit imprimé (20) présente un évidement (28) complémentaire à la broche de positionnement (50) pour recevoir la broche de positionnement (50), la broche de positionnement (50) étant agencée au moins partiellement dans l'évidement (28).

4. Module de commande électronique (10) selon la revendication 3, dans lequel
une partie aplatie de la broche de positionnement (50) destinée à fixer le composant électronique (30) sur la carte à circuit imprimé (20) repose sur une face arrière (26) de la carte à circuit imprimé (20) opposée à la surface (25) de la carte à circuit imprimé (20).

5. Procédé de fabrication d'un module de commande électronique (10), notamment d'un module de commande électronique (10) selon l'une des revendications précédentes,
le procédé comprenant les étapes suivantes :
fournir une carte à circuit imprimé (20) avec au moins un élément de connexion (40, 41) relié électriquement et mécaniquement à la carte à circuit imprimé (20), en particulier au moyen d'un assemblage par brasage, de préférence un assemblage par brasage par refusion,
l'élément de connexion (40, 41) étant conçu de manière élastique dans une direction qui est perpendiculaire à une surface (25) de la carte à circuit imprimé (20) ;
fournir un composant électronique (30) ayant au moins une surface de contact (35, 36) pour connecter électriquement le composant électronique (30) ; et
placer le composant électronique (30) sur la surface (25) de la carte à circuit imprimé (20) de telle sorte que la surface de contact (35, 36) du composant électronique (30) entre en contact avec l'élément de connexion (40, 41) pour établir une connexion électrique entre le composant électronique (30) et la carte à circuit imprimé (20),
le procédé comprenant en outre les étapes suivantes après la mise en place du composant électronique (30) sur la surface (25) de la carte à circuit imprimé (20) :
application d'un matériau d'encapsulation liquide (80) sur la surface (25) de la carte à circuit imprimé (20) de telle sorte que le matériau d'encapsulation (80) recouvre de manière étanche aux liquides au moins une partie de la surface (25) de la carte à circuit imprimé (20), une partie du composant électronique (30) et une partie de l'élément de connexion (40, 41) avec une masse d'encapsulation ; et
durcir le matériau d'encapsulation (80), deux éléments de connexion (40, 41) reliés électriquement et mécaniquement à la carte à circuit imprimé (20), notamment au moyen d'une connexion par brasage, de préférence une connexion par brasage par refusion, étant agencés sur la carte à circuit imprimé (20), et le composant électronique (30) étant agencé sur la carte à circuit imprimé (20) de telle sorte que les deux éléments de connexion (40, 41) sont reliés électriquement chacun à une surface de contact (35, 36) du composant électronique (30),
le composant électronique (30) présentant une paroi de séparation (70), le composant électronique (30) étant agencé sur la surface (25) de la carte à circuit imprimé (20) de telle sorte que la paroi de séparation (70) est agencée entre les deux éléments de connexion (40, 41), et le matériau d'encapsulation (80) étant appliqué sur la surface (25) de la carte à circuit imprimé (20) de telle sorte que, grâce au matériau d'encapsulation (80) et à la paroi de séparation (70), les deux éléments de connexion (40, 41) sont agencés dans deux chambres (45, 46) séparées l'une de l'autre par la paroi de séparation (70) .

6. Procédé selon la revendication 5, dans lequel
le composant électronique (30) comporte une broche de positionnement (50) pour orienter le composant électronique (30) par rapport à la carte à circuit imprimé (20) et la carte à circuit imprimé (20) comporte un évidement (28) complémentaire à la broche de positionnement (50) pour recevoir la broche de positionnement (50), et dans lequel le composant électronique (30) est agencé sur la surface (25) de la carte à circuit imprimé (20) de telle sorte que la broche de positionnement (50) soit agencée au moins partiellement dans l'évidement (28).
